Europäisches Patentamt

European Patent Office

Office européen des brevets

(11) Publication number: **0 209 257 B1**

# EUROPEAN PATENT SPECIFICATION

(45) Date of publication of patent specification: **20.05.92**

(51) Int. Cl.⁵: **C30B 31/22**, C30B 29/04, C30B 1/02

(21) Application number: **86304646.2**

(22) Date of filing: **17.06.86**

(54) **Ion implantation.**

(30) Priority: **17.06.85 ZA 854552**
       **11.07.85 ZA 855239**

(43) Date of publication of application:
      **21.01.87 Bulletin 87/04**

(45) Publication of the grant of the patent:
      **20.05.92 Bulletin 92/21**

(84) Designated Contracting States:
      **BE CH DE GB LI NL**

(56) References cited:
      **EP-A- 0 033 506**
      **DE-A- 1 544 190**

**JOURNAL OF APPLIED PHYSICS, vol. 51, no. 5, May 1980, pages 2625-2629, American Institute of Physics, New York, US; S. MATTESON et al.: "Epitaxial regrowth of Ar implanted amorphous Si by laser annealing"**

**JOURNAL OF APPLIED PHYSICS, vol. 49, no. 10, October 1978, pages 5199-5206, American Institute of Physics, New York, US; P. REVESZ et al.: "Epitaxial regrowth of Ar-implanted amorphous silicon"**

(73) Proprietor: **DE BEERS INDUSTRIAL DIAMOND DIVISION (PROPRIETARY) LIMITED**
      **8th Floor 45 Main Street**
      **Johannesburg Transvaal(ZA)**

(72) Inventor: **Prins, Johan Frans**
      **8 Portland Place Northcliff Extension 15**
      **Johannesburg Transvaal(ZA)**

(74) Representative: **Ellis-Jones, Patrick George Armine et al**
      **J.A. KEMP & CO. 14 South Square Gray's Inn**
      **London WC1R 5EU(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.08/2.19/2.0)

## Description

### BACKGROUND OF THE INVENTION

This invention relates to ion implantation.

Ion implantation is a known technique involving bombarding a substrate with energetic ions, which are preferably positive ions. The ions penetrate the substrate and also form a thin film on and in the surface of the substrate. The apparatus for carrying out ion implantation includes a source for producing a beam of ions, an accelerator for accelerating the ions and a filter for screening out unwanted ions from the beam. The apparatus may also include a device for sweeping the beam across the substrate.

A wide range of ion energies from a few eV to MeV may be employed. The greater the energy the greater will be the penetration of the ions into the substrate. The extent of damage is dependent on the dose of ions implanted.

When an ion during the implantation process penetrates a crystal lattice it first loses energy, mostly by electronic interactions with the material. This process slows the ion down. When it reaches a certain slower speed, the ion starts to interact with the nuclei of the lattice atoms causing collision displacement of these atoms. In turn, the atoms being displaced can collide with other atoms causing a cascade of collision interactions. After the event, the area in which the cascade occurred will contain atoms displaced from their lattice positions (interstitials) and empty lattice sites where atoms should have been (vacancies). These two crystal defects can, at the appropriate temperature, migrate through the crystal and may even meet up and annihilate each other, i.e. when an interstitial jumps into a vacancy the previously displaced atom is again in a lattice position and the previously empty site is again filled. If it were possible to induce all the displaced atoms to migrate to and jump into vacancies the radiation damage caused during ion implantation would be removed.

The diffusibility of interstitial atoms and vacancies is temperature dependent. In many solids, the interstitials become mobile at lower temperatures than the vacancies. For example, it seems that in diamond the interstitials become mobile at temperatures of about 50 to 100°C. The vacancies, on the other hand, start to diffuse at temperatures above 600°C.

When a point defect like an interstitial migrates by diffusion, the chance that it may encounter a vacancy and recombine with it, depends on the density of the vacancies present. The higher the number of vacancies present the larger the probability that the interstitial will end up recombining with a vacancy before diffusing out of the ion damaged layer.

A wide variety of substrates may be subjected to ion implantation. For example, it is known to implant diamonds with a variety of ions such as carbon, boron or nitrogen.

### SUMMARY OF THE INVENTION

According to the present invention, there is provided a method of producing a doped diamond wherein dopant atoms are in lattice positions in the diamond crystal lattice which comprises:

(a) bombarding a diamond substrate having a crystal lattice with ions of a suitable energy to produce within the crystal lattice a damaged layer of point defects in the form of vacancies and interstitials, the bombardment being carried out at a temperature sufficiently low to inhibit the diffusion of the point defects;

(b) introducing dopant atoms into the damaged layer by ion implantation during, before or after the damage-creating bombardment, the dopant atom implantation also taking place at a temperature sufficiently low to inhibit the diffusion of the point defects in the damaged layer; and

(c) annealing the damaged layer to cause the vacancies and interstitial atoms to diffuse and thereby reduce the lattice damage and to cause dopant interstitial atoms to diffuse into lattice positions.

### DETAILED DESCRIPTION OF THE INVENTION

The substrate (diamond) will be damaged in the manner described above, and the substrate also subjected to bombardment by dopant ions. The substrate will be maintained at its low temperature during both bombardments. The bombardments may take place in any order or simultaneously.

The low temperature will generally be such that substantially all the point defects produced in the substrate are immobilised or frozen in and do not diffuse. The temperature will generally be substantially below 0°C and typically the temperature of liquid nitrogen or lower.

An interesting effect occurs when ion-implanting a material at a low enough temperature to freeze in the point defects. Once radiation damage has been created, the atoms taking part in the collision cascade will not just be atoms which are being knocked out of lattice positions, but also atoms which were already displaced from lattice positions during previous collision cascades. Accordingly, less vacancies are created per cascade, than would have been the case if no interstitial atoms were present. Furthermore, some of the atoms taking part in the collision cascade will end up stopping at existing vacant lattice positions, further decreasing the number of vacancies and interstitials. Obviously, the more vacancies and interstitial atoms already present, the lower the increase in vacancies and interstitials per impinging ion will be. Provided the implanted region does not become amorphous, it is theoretically possible to reach a stage where as many vacancies and interstitials recombine as are created in the collision cascade, thus causing no net increase in radiation damage per implanted ion.

Although the net number of vacancies and interstitials created per impinging ion decreases with an increase in radiation damage, each cascade created by an impinging ion causes mixing of the atoms: i.e. atoms which were in lattice positions end up in interstitial positions whereas atoms which were in interstitial positions in turn end up in lattice positions. Furthermore, the large number of vacancies present also increases the possibility that the ion, being implanted, will end up in a lattice position.

The invention has particular application to introducing standard dopant atoms such as boron, phosphorus, arsenic and the like into lattice positions in a diamond substrate. The preferred method of carrying out this invention in this regard is as follows:

The diamond is first damaged by carbon-ion-implantation at a suitable ion energy or range of energies, depending on the required width and depth of the damaged region needed. The ion dose used must be high enough to create a high density of vacancies and interstitials, but low enough to ensure that the damage can be annealed out afterwards without causing the diamond to amorphise or other stable defect clusters to form which may interfere with the electrical activity of the dopants to be introduced. Even if some defects do remain after annealing, their density must be low enough not to interfere in a major way with the required electrical and/or optical properties of the doped specimen.

Other ions may also be used to effect the pre-damage as long as these ions also do not in the end interfere with the required properties. For example, any ion, which when located in the diamond crystal, does not create extra energy levels in the band gap, could be suitable. However, carbon ions are preferred.

The damage-creating implantation is then immediately followed by implantation of the dopant ions at a suitable energy or range of energies to ensure that the dopant ions will come to rest in the previously damaged crystal region. The large number of vacancies and interstitials already present will thus increase the probability that the impinging dopant ion will end up in a lattice position. Furthermore, the mixing action experienced in each cascade caused by subsequent dopant ions impinging on the damaged layer, will further increase the likelihood that dopant atoms, present in the layer but not yet in lattice positions, being knocked into vacant lattice sites. It is also possible to ion-implant the dopant ions first and then follow this by implanting the damage ions (carbon ions), which then in turn will create the necessary vacancies and knock dopant ions into them by the mixing action experienced in the collision cascades. Alternatively the implantation of the damaged ions and dopant ions may be alternated or done simultaneously.

Both ion bombardments are performed at a low enough temperature to ensure that the point defects are frozen in and do not diffuse. A suitable temperature for diamond will be liquid nitrogen temperature or lower. Even higher temperatures are possible as long as diffusion is limited.

After completion of the ion implantation, the crystal lattice will contain a high density of vacancies and self-interstitials (carbon interstitials) and the dopant atoms, some of which will already be in lattice sites. More dopant atoms may now be driven into lattice positions and the radiation damage diminished to a low level (or removed) by a suitably chosen annealing cycle. By heating the diamond the interstitial atoms (self-interstitials like carbon and dopant interstitials) and/or the vacancies will start to diffuse. Owing to the high density of interstitials and vacancies many of them will meet up and annihilate. When a carbon interstitial and vacancy combine, the radiation damage becomes less. On the other hand, if a dopant interstitial and vacancy meet, the dopant atom ends up in a lattice position.

The diffusion mobility of the self-interstitials (carbon interstitials) and vacancies will, in general, be different at a given annealing temperature. For example a large dopant atom (for example arsenic) may not be able to diffuse by an interstitial mechanism at a reasonable annealing temperature. In this case, the large interstitial dopant atom will only end up in a lattice position if a vacancy or vacancies diffuse towards it in order to meet up with it. Clearly, the best annealing result will thus depend on the annealing temperature or temperature cycle chosen. The annealing cycle should be chosen to ensure the maximum interstitial - (self and dopant) - vacancy recombination. Depending on the pre-damage ion dose and dopant dose, various annealing techniques may be employed, for example::

(a) Ordinary vacuum annealing up to a temperature of about 1500°C. Above 100°C and to 600°C the self-interstitials will diffuse and above 600°C the vacancies and interstitials will both migrate. The rate at which the temperature is increased will obviously affect the amount of dopant activation and residual radiation damage.

(b) Ultra-high vacuum annealing: In this case the temperature may safely be increased to nearly 2000°C for short times without graphitising the diamond. With care even higher temperatures may be used. The higher the temperature, the more mobile the point defects will become. Again the rate of temperature increase should affect the end result. Short time flash anneals may even be more advantageous.

(c) Thermal annealing while applying a force field across the damaged layer: The point defects in diamond are charged and their movement is affected by application of electrical or other force fields. Thus when heating the diamond after implantation while applying a force field (steady or alternating) the number of jumps and direction of movement of the point defects during diffusion may be controlled.

(d) Ultra-high pressure annealing: Annealing the diamond under high pressure in the diamond stable region will supply a further handle in controlling the recombination process between vacancies and interstitials. Under high enough pressures (120kbar) it will be possible to heat the diamond for short periods up to 2500°C without graphitising it. Even at lower temperatures the pressure will also affect the mobility of the point defects and their attraction towards each other.

(e) Laser annealing, e.g. as described in South African Patent No. 82/1177.

The method of the invention can be used to produce a damaged layer in the substrate which has a concentration of point defects such that the structure may be considered as randomised or amorphised, the bombardment being carried out at a temperature sufficiently low to inhibit expansion of the damaged layer to a region of lower density. The damaged layer can then still be annealed under conditions suitable to produce epitaxial growth or recrystallisation even though it may be difficult to distinguish between vacancies and interstitials after ion implantation.

Examples of conditions suitable to produce epitaxial growth or recrystallisation are as follows:

1. Conditions of elevated temperature and pressure under which the substrate is crystallographically stable. Such conditions are known in the art.

2. Use of laser annealing.

3. Heating the damaged substrate at a temperature up to 2000°C under high vacuum. Typically temperatures are in the range 500°C to 2000°C and typically vacuums are those in the range ($10^{-6}$ to $10^{-11}$ Torr) $1.3 \times 10^{-4}$ to $1.3 \times 10^{-9}$ Pa.

In order to test the effectiveness of the method of the invention, experiments were done in an attempt to dope type IIa diamonds with nitrogen. The majority of diamonds contain nitrogen in one form or another. The amount and type of nitrogen present affects the optical absorption spectrum. Type IIa diamonds contain very little nitrogen and their absorption spectrum does not contain any absorption bands which may be attributed to nitrogen. The very rare Type Ib diamonds contain a large amount of nitrogen ($\sim 10^{-19}$ atoms/cm$^3$) in dispersed form, i.e. single nitrogen atoms in lattice positions, and are thus effectively "doped" with nitrogen atoms. The presence of the dispersed nitrogen causes the diamond to absorb light in the blue and ultra-violet spectrum giving it a gold-yellow colour. When a diamond contains radiation damage (vacancies and interstitials) it also displays specific adsorption characteristics in the optical spectrum. The dominant radiation damage bands are the GR1-band, centered around a photon energy of about 2 eV., and attributable to vacancies, and a large radiation-damage band in the ultra-violet region of the spectrum.

If it were now possible to introduce nitrogen atoms substitutionally into a IIa diamond its optical absorption spectrum should change from a typical IIa-spectrum to one containing Ib characteristics. Three IIa diamonds were chosen and implanted at liquid nitrogen temperature under the following conditions:

(i) Diamond 1: This diamond was pre-damaged using carbon ion implantation at an energy of 100 keV. to a dose of $4 \times 10^{14}$ ions/cm$^2$. This was immediately followed by an implantation of nitrogen ions at an energy of 110 keV. to a dose of $1 \times 10^{14}$ ions/cm$^2$. The latter energy ensured that the carbon implanted and nitrogen implanted regions overlap and the ion dose gave an average nitrogen atom density of $\sim 2 \times 10^{19}$ atoms/cm$^3$ after implantation in the previously implanted layer.

(ii) Diamond 2: This diamond was implanted using only carbon ions up to an ion dose of $5 \times 10^{14}$ ions/cm$^2$, thus causing about the same amount of radiation damage as in diamond 1, but without nitrogen being introduced.

(iii) Diamond 3: In this diamond only nitrogen ions were implanted, without pre-damaging the diamond, up to a dose of $1 \times 10^{14}$ ions/cm$^2$. Thus after ion implantation, the diamond contained the same density of implanted nitrogen atoms in the implanted region as diamond 1, i.e. $\sim 2 \times 10^{19}$ atoms/cm$^3$.

The optical spectra of these diamonds were then studied after different isochronal annealing stages up to a temperature of about 800°C. The results confirm that the effectiveness of the process of the invention:

(i) Diamond 1: This diamond showed type Ib optical absorption characteristics and the G.R.1- and UV-radiation damage bands after ion implantation. The latter disappeared after the annealing while the Ib characteristics became stronger: thus indicating that many nitrogen atoms have been incorporated substitutionally during the implantation and annealing process.

(ii) Diamond 2: This diamond displayed only IIa optical absorption characteristics on which the GR. 1- and UV-radiation bands were superposed. After annealing, these radiation-damage bands disappeared leaving only the original type IIb absorption spectrum, i.e. the residual radiation damage was low enough not to be observed optically. This result adds further proof that nitrogen atoms were incorporated substitutionally into diamond 1.

(iii) Diamond 3: After ion implantation this diamond showed weak radiation damage bands and a very small effect where the nitrogen absorption peaks should be. After annealing the radiation bands disappeared but no Ib absorption characteristics emerged.

## Claims

1. A method of producing a doped diamond wherein dopant atoms are in lattice positions in the diamond crystal lattice which comprises:

   (a) bombarding a diamond substrate having a crystal lattice with ions of a suitable energy to produce within the crystal lattice a damaged layer of point defects in the form of vacancies and interstitials, the bombardment being carried out at a temperature sufficiently low to inhibit the diffusion of the point defects;

   (b) introducing dopant atoms into the damaged layer by ion implantation during, before or after the damage-creating bombardment, the dopant atom implantation also taking place at a temperature sufficiently low to inhibit the diffusion of the point defects in the damaged layer; and

   (c) annealing the damaged layer to cause the vacancies and interstitial atoms to diffuse and thereby reduce the lattice damage and to cause dopant interstitial atoms to diffuse into lattice positions.

2. A method according to claim 1 wherein the dopant atoms are boron, phosphorus or arsenic.

3. A method according to claim 1 or 2 wherein the ions of the damage-creating bombardment are carbon ions.

4. A method according to any one of claims 1 to 3 wherein the low temperature is substantially below 0°C.

5. A method according to claim 4 wherein the low temperature is that of liquid nitrogen or lower.

6. A method according to any one of the preceding claims wherein the annealing used is vacuum annealing up to a temperature of 1500°C.

7. A method according to any one of claims 1 to 5 wherein the annealing is ultra-high vacuum annealing at a temperature of up to 2000°C.

8. A method according to any one of claims 1 to 5 wherein the annealing is thermal annealing carried out while a force field is applied across the damaged layer.

9. A method according to any one of claims 1 to 5 wherein the annealing is ultra-high pressure annealing.

10. A method according to any one of claims 1 to 5 wherein the annealing is carried out by laser annealing.

## Revendications

1. Procédé de production d'un diamant dopé dans lequel les atomes dopants se trouvent dans des positions du réseau cristallin du diamant :

   a) le bombardement d'un substrat de diamant comportant un réseau cristallin avec des ions d'une énergie appropriée pour produire, à l'intérieur du réseau cristallin, une couche endommagée de défauts ponctuels sous la forme de lacunes et d'atomes intersticiels, le bombardement étant effectué à une température suffisamment basse pour empêcher la diffusion des défauts ponctuels;

   b) l'introduction d'atomes dopants dans la couche endommagée par l'implantation d'ions pendant, avant ou après le bombardement créateur de dommages, l'implantation d'atomes dopants se faisant également à une température suffisamment basse pour empêcher la diffusion des défauts ponctuels dans la couche endommagée, et

c) le recuit de la couche endommagée pour amener les lacunes et les atomes intersticiels à diffuser et ainsi à réduire les dommages du réseau, ainsi que pour amener les atomes intersticiels dopants à diffuser dans les positions du réseau.

2. Procédé suivant la revendication 1, dans lequel les atomes dopants sont des atomes de bore, de phosphore ou d'arsenic.

3. Procédé suivant la revendication 1 ou 2 dans lequel les ions du bombardement créateur de dommages sont des ions carbone.

4. Procédé suivant l'une quelconque des revendications 1 à 3, dans lequel la basse température est sensiblement inférieure à 0°C.

5. Procédé suivant la revendication 4, dans lequel la basse température est celle de l'azote liquide ou plus basse.

6. Procédé suivant l'une quelconque des revendications précédentes, dans lequel le recuit utilisé est un recuit sous vide à une température pouvant aller jusqu'à 1500°C.

7. Procédé suivant l'une quelconque des revendications 1 à 5, dans lequel le recuit est un recuit sous vide ultra-élevé à une température pouvant aller jusqu'à 2000°C.

8. Procédé suivant l'une quelconque des revendications 1 à 5, dans lequel le recuit est un recuit thermique effectué tandis qu'un champ de force est appliqué en travers de la couche endommagée.

9. Procédé suivant l'une quelconque des revendications 1 à 5, dans lequel le recuit est un recuit sous pression ultra-élevée.

10. Procédé suivant l'une quelconque des revendications 1 à 5, dans lequel le recuit est effectué à l'aide d'un laser.

**Patentansprüche**

1. Verfahren zur Herstellung eines dotierten Diamants, worin die Atome des Dotierungsmittels sich in Gitter-Positionen des Diamant-Gitters befinden, umfassend

(a) den Beschuß eines ein Kristallgitter besitzenden Diamant-Substrats mit Ionen geeigneter Energie zur Erzeugung einer beschädigten Schicht von punktförmigen Fehlstellen in Form von Leerstellen und Atomen auf Zwischengitterplätzen innerhalb des Kristallgitters, wobei der Beschuß bei hinreichend niedriger Temperatur durchgeführt wird, um die Diffusion der punktförmigen Fehlstellen zu hemmen;

(b) das Einführen von Dotierungsmittel-Atomen in die beschädigte Schicht durch Ionenimplantierung während des schädigenden Beschusses oder vor oder nach dem schädigenden Beschuß, wobei die Implantierung des Dotierungsmittel-Atoms ebenfalls bei hinreichend niedriger Temperatur durchgeführt wird, um die Diffusion der punktförmigen Fehlstellen in der beschädigten Schicht zu hemmen; und

(c) das Tempern der beschädigten Schicht, um eine Diffusion der Leerstellen und Atome auf den Zwischengitterplätzen zu bewirken und dadurch die Gitter-Schäden zu reduzieren und eine Diffusion von Dotierungsmittel-Atomen auf Zwischengitterplätzen in Gitter-Positionen zu bewirken.

2. Verfahren nach Anspruch 1, worin die Dotierungsmittel-Atome Bor, Phosphor oder Arsen sind.

3. Verfahren nach Anspruch 1 oder 2, worin die Ionen des die Beschädigung erzeugenden Beschusses Kohlenstoff-Ionen sind.

4. Verfahren nach irgendeinem der Ansprüche 1 bis 3, worin die niedrige Temperatur im wesentlichen unter 0 °C liegt.

5. Verfahren nach Anspruch 4, worin die niedrige Temperatur diejenige von flüssigem Stickstoff ist oder darunter liegt.

6. Verfahren nach irgendeinem der vorhergehenden Ansprüche, worin das angewandte Tempern ein Tempern im Vakuum bei einer Temperatur bis zu 1500 °C ist.

7. Verfahren nach irgendeinem der Ansprüche 1 bis 5, worin das Tempern ein Tempern im Ultrahochvakuum bei einer Temperatur bis zu 2000 °C ist.

8.  Verfahren nach irgendeinem der Ansprüche 1 bis 5, worin das Tempern ein thermisches Tempern ist, das unter Anlegen eines Kraftfeldes über die beschädigte Schicht durchgeführt wird.

9.  Verfahren nach irgendeinem der Ansprüche 1 bis 5, worin das Tempern ein Ultrahochdruck-Tempern ist.

10. Verfahren nach irgendeinem der Ansprüche 1 bis 5, worin das Tempern mittels Laser-Tempern durchgeführt wird.